# EUROPÄISCHE PATENTSCHRIFT

(11) **EP 0 705 386 B1**
(45) Veröffentlichungstag und Bekanntmachung des Hinweises auf die Patenterteilung: **03.09.1997**
(21) Anmeldenummer: 94917556.6
(22) Anmeldetag: 18.06.1994
(51) Int. Cl.: F02P 17/00, H03K 5/01

(54) **VERFAHREN ZUR ERKENNUNG EINER ZÜNDIMPULSGRUPPE**
PROCESS FOR DETECTING AN IGNITION PULSE GROUP
PROCEDE PERMETTANT DE DETECTER UN GROUPE D'IMPULSIONS D'ALLUMAGE

(30) Priorität: 25.06.1993 DE 4321170
(43) Veröffentlichungstag der Anmeldung: 10.04.1996
(73) Patentinhaber: ROBERT BOSCH GMBH, 70442 Stuttgart (DE)
(72) Erfinder: DITTMANN, Karl-Heinz, D-73054 Eislingen (DE); FISCHER, Uwe, D-71409 Schwaikheim (DE)
(86) Internationale Anmeldenummer: DE9400675
(87) Internationale Veröffentlichungsnummer: WO9500755

(56) Entgegenhaltungen:
- WO-A-91/15678
- DE-A- 1 537 328
- US-A- 3 970 872
- US-A- 4 686 953
- US-A- 5 128 973

## Beschreibung

### Stand der Technik

Die Erfindung geht aus von einem Verfahren zum Prüfen einer fremdgezündeten Brennkraftmaschine nach der Gattung des Hauptanspruchs. Aus dem Fachbuch von P. PAULSEN, "Elektronische Motortestgeräte", Franzis-Verlag, 1977 sind im Kapitel 4.12 auf Seiten 78 - 84 elektronische Drehzahlmeßgeräte beschrieben, die jeweils eine monostabile Kippstufe am Eingang aufweisen. Die bekannten Drehzahlmeßgeräte leiten ein impulsförmiges Signal aus der Zündanlage der Brennkraftmaschine ab, das mit der monostabilen Kippstufe in ein Rechtecksignal umgesetzt wird. Der Einsatz der monostabilen Kippstufe reduziert den Einfluß von Störsignalen, die während der aktiven Phase der Kippstufe unterdrückt werden.

DE-A-1 537 328 beschreibt ein Verfahren zu Prüfen einer fremdgezündeten Brennkraftmaschine, bei dem ein impulsförmiges Signal bereitgestellt wird, das jedem Schaltvorgang einen Impuls zuordnet. Dabei erfolgt eine Impulsverarbeitung mit einem retriggerbaren Zeitgeber, dem die Impulse zugeführt werden und der ein Triggersignal abgibt, aus dem zumindest die Drehzahl der Brennkraftmaschine ermittelbar ist. Eine monostabile Kippstufe, der das abgeleitete Signal zugeleitet wird, stellt die Impulse mit einer vorgegebenen Dauer bereit.

Der Erfindung liegt die Aufgabe zugrunde, ein Verfahren zum Prüfen einer fremdgezündeten Brennkraftmaschine anzugeben, das die Bereitstellung eines aus der Zündanlage abgeleiteten Signals ermöglicht, das weitgehend frei von unerwünschten Signalanteilen ist.

Die Aufgabe wird durch die im Hauptanspruch angegebenen Merkmale gelöst.

### Vorteile der Erfindung

Erfindungsgemäß ist vorgesehen, daß ein erster Impuls einer Impulsgruppe des aus der Zündanlage abgeleiteten impulsförmigen Signals, das jedem in der Zündanlage auftretenden Schaltvorgang einen Impuls zuordnet, einen retriggerbaren Zeitgeber startet, dessen aktive Phase länger ist als der maximale Abstand zwischen den Impulsen einer gegebenenfalls auftretenden Impulsgruppe. Mit dieser Maßnahme ist es möglich, die nach dem ersten Impuls folgenden Impulse der Gruppe zu unterdrücken. Das erfindungsgemäße Verfahren unterdrückt insbesondere diejenigen Impulse, die jedem in der Zündanlage auftretenden Schaltvorgang entsprechen, die nach dem ersten Impuls einer Funkenbandzündung auftreten.

Die Funkenbandzündung sieht vor, daß zumindest in bestimmten Betriebssituationen einer Brennkraftmaschine, beispielsweise bei niedrigen Drehzahlen oder beim Kaltstart anstelle eines einzigen Zündfunkens in rascher zeitlicher Folge eine Impulsfunkengruppe erzeugt wird. Die Impulsfunkengruppe ist auf einen vorgegebenen Bereich des Kurbelwellenwinkels festgelegt. Der Abstand zwischen den Impulsen einer Impulsgruppe auf den die für den Zeitgeber vorzugebende Zeit abzustimmen ist, kann deshalb als bekannt angenommen werden.

Ein wesentlicher Vorteil des erfindungsgemäßen Verfahrens liegt darin, daß die bekannte Schaltungstechnik von Vorrichtungen zum Prüfen einer fremdgezündeten Brennkraftmaschine, insbesondere der Triggerteil, weiterhin verwendet werden können. Das erfindunsgemäße Verfahren liefert der Vorrichtung die Information, welche Impulse zu unterdrücken sind. Das erfindungsgemäße Verfahren ermöglicht beispielsweise eine Ermittlung der Drehzahl der Brennkraftmaschine aus Impulsen, die in der Zündanlage auftreten, ohne daß es zu Störungen oder zu Fehlmessungen durch die weiteren Impulse der Impulsgruppe bei einer Funkenbandzündung kommt.

Vorteilhafte Weiterbildungen und Verbesserungen des erfindungsgemäßen Verfahrens ergeben sich aus Unteransprüchen.

Eine vorteilhafte Ausgestaltung sieht vor, daß die für den Zeitgeber vorzugebende Zeit länger ist als die maximale erwartete Zündfunkenstandzeit. Die maximale Zündfunkenstandzeit kann länger sein als der maximale Abstand zwischen den Impulsen einer Impulsgruppe. Mit dieser Maßnahme wird eine weitergehende Erhöhung der Festigkeit gegenüber Störsignalen erreicht. Eine solche Störung könnte beispielsweise beim Funkenabriß auftreten.

Eine besonders vorteilhafte Weiterbildung sieht vor, daß der retriggerbare Zeitgeber abgeschaltet wird, wenn die Drehzahl der Brennkraftmaschine einen vorgegebenen Schwellwert übersteigt. Bei höheren Drehzahlen ist eine Funkenbandzündung nicht vorgesehen. Die vorgeschlagene Maßnahme ermöglicht eine Verarbeitung von Zündimpulsen somit auch bei höchsten Drehzahlen, bei denen die Abstände zwischen den Zündfunken in den Zeitbereich kommen, der dem retriggerbaren Zeitgeber zugeordnet ist.

Eine andere Ausgestaltung, die gegebenenfalls mit der bereits beschriebenen Abschaltung des retriggerbaren Zeitgebers kombiniert werden kann; sieht vor, daß die für den Zeitgeber vorzugebende Zeit in Abhängigkeit von der Drehzahl festgelegt wird und sich somit über einen konstanten Winkel erstreckt.

Eine andere Möglichkeit, die für den Zeitgeber vorzugebende Zeit an die Betriebssituation der Brennkraftmaschine anzupassen, sieht vor, daß die Zeitfestlegung in Abhängigkeit vom Auftreten zu unterdrückenden Impulsen vorgenommen wird.

Weitere Möglichkeiten zur Festlegung der vorzugebenden Zeit sehen die Einbeziehung sowohl der Kenndaten der Brennkraftmaschine als auch die der eingesetzten Zündanlage vor. Vorzugsweise wird die Zylinderanzahl berücksichtigt. Bei Zündanlagen kann unterschieden werden zwischen einfachen Zündanlagen mit rotierender Hochspannungsverteilung, Zündanlagen mit zweifach rotierender Hochspannungsverteilung, Zündanlagen mit ruhender Hochspannungsverteilung mit Einzelfunken- oder Doppelfunkenerzeugung und beispielsweise Zündanlagen mit symmetrischer oder unsymmetrischer Zündfolge.

Weitere vorteilhafte Weiterbildungen und Ausgestaltungen des erfindungsgemäßen Verfahrens ergeben sich aus weiteren Unteransprüchen in Verbindung mit der folgenden Beschreibung.

### Zeichnung

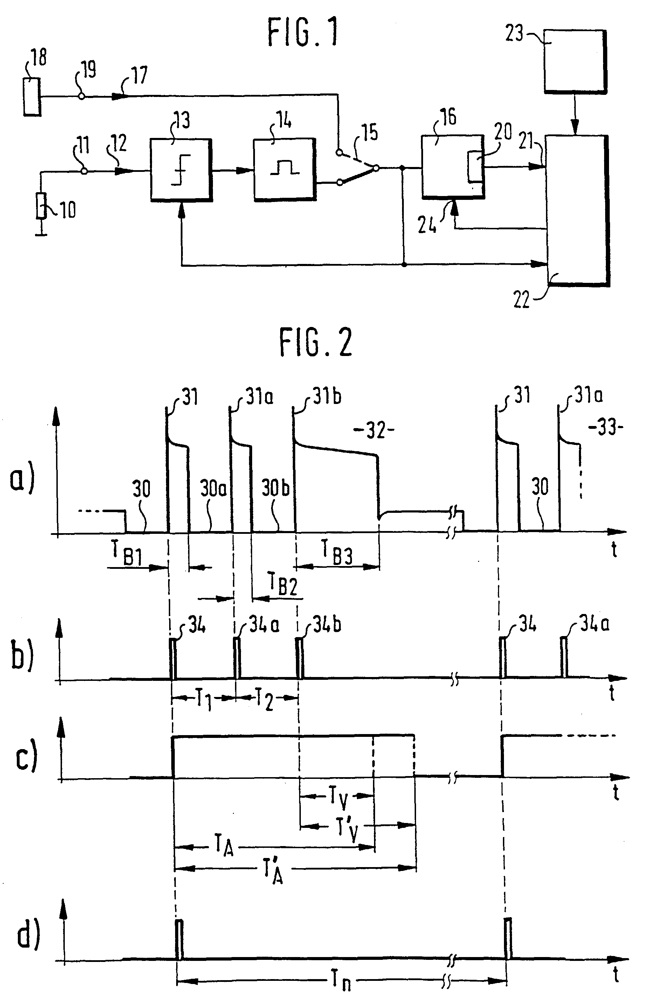

Figur 1 zeigt ein Blockschaltbild einer Vorrichtung zum Prüfen einer fremdgezündeten Brennkraftmaschine und Figur 2 zeigt Signalverläufe, die in der Vorrichtung auftreten.

Die in Figur 1 gezeigte Vorrichtung enthält einen Sensor 10, der an einem ersten Eingang 11 angeschlossen ist. Ein erstes Eingangssignal 12 ist einem Komparator 13 zugeführt, der ein Ausgangssignal an eine monostabile Kippstufe 14 abgibt. Die Kippstufe 14 gibt ein Ausgangssignal an einen Umschalter 15 ab, der ein Eingangssignal eines retriggerbaren Zeitgebers 16 auswählt. Das Ausgangssignal der monostabilen Kippstufe 14 ist ein erstes mögliches Eingangssignal des retriggerbaren Zeitgebers 16. Ein anderes mögliches Eingangssignal ist ein Zündfunkenunterdrückungssignal 17, das von einer Zündfunkenunterdrückungsvorrichtung 18 über einen zweiten Eingang 19 dem Umschalter 15 zugeleitet ist.

Der retriggerbare Zeitgeber 16 enthält eine Differenzieranordnung 20, die ein Triggersignal 21 an eine signalverarbeitende Anordnung 22 abgibt. Das Eingangssignal des retriggerbaren Zeitgebers 16 wird ebenfalls der signalverarbeitenden Anordnung 22 und zusätzlich dem Komparator 13 zugeleitet. Weiterhin erhält die signalverarbeitende Anordnung 22 ein Eingangssignal zugeführt, das von einer Eingabe 23 abgegeben wird. Die signalverarbeitende Anordnung gibt ein Steuersignal 24 an den retriggerbaren Zeitgeber 16 ab.

Das erfindungsgemäße Verfahren und die Funktionsweise der in Figur 1 gezeigten Vorrichtung wird anhand der in Figur 2 gezeigten Signalverläufe, die an unterschiedlichen Stellen in der Vorrichtung auftreten, näher erläutert:

Die in Figur 1 gezeigte Vorrichtung ist Teil eines Motortesters, der beispielsweise die Drehzahl einer fremdgezündeten Brennkraftmaschine erfaßt. Der Sensor 10 erfaßt in einer nicht näher gezeigten Zündanlage der Brennkraftmaschine ein Signal, das bei Schaltvorgängen auftritt. Im Ausführungsbeispiel ist der Sensor 10 als induktiver Sensor ausgebildet. Ein derartiger induktiver Sensor erfaßt einen Strom, der beispielsweise in einem Zündungsschaltgerät oder in einem Primär- oder Sekundärkreis einer Zündspule auftritt. Anstelle der Ausgestaltung des Sensors 10 als induktiver Sensor kann auch eine Ausgestaltung als kapazitiver Sensor vorgesehen sein. Ein derartiger kapazitiver Sensor ist beispielsweise ein Anklemm- oder Ansteckteil, das an einer geeigneten Stelle in der Zündanlage eine Spannung erfaßt. Der Sensor 10 kann auch ersetzt sein durch eine galvanische Verbindung des ersten Eingangs 11 mit einem Anschlußpunkt in der Zündanlage.

Die zweckmäßige Festlegung des Sensors 10 hängt von der Ausgestaltung der Zündanlage ab. Vorgesehen können herkömmliche Anlagen mit rotierender Hochspannungsverteilung sein. Als Zündanlagen können auch verteilerlose Anlagen mit Einzelfunken- oder Doppelfunkenzündung vorhanden sein. Die Zündanlagen können sowohl symmetrische als auch unsymmetrische Zündimpulsfolgen aufweisen.

Ein möglicher Verlauf des ersten Eingangssignals 12 ist im Teilbild a von Figur 2 gezeigt. Das Teilbild a zeigt einen Spannungsverlauf in Abhängigkeit von der Zeit, der an einem Zündungsschaltgeräteanschluß auftritt, der mit einer Primärwicklung einer Zündspule verbunden ist. Dieser Anschluß wird als Klemme-l-Anschluß bezeichnet. Während einer ersten Schließphase 30 wird in einer Zündspule ein magnetisches Feld aufgebaut. Zum vorgegebenen Zündzeitpunkt wird der Stromfluß unterbrochen. Ein einsetzender Schwingvorgang mit hoher Amplitude führt zu einem Hochspannungsimpuls 31, der den Zündvorgang an einer Zündkerze einleitet. Nach dem Einleiten des Zündvorgangs steht der Zündfunken an der Zündkerze solange an, bis entweder die zur Verfügung stehende Energie zum Aufrechterhalten des Funkens nicht mehr ausreicht oder bis eine Abschaltung erfolgt. Die erste Funkenstandzeit ist mit T_{B1} bezeichnet. Eine Abschaltung des Zündfunkens und eine erneute Einleitung einer Schließphase 30a ist bei einer Funkenbandzündung vorgesehen, bei der in Abhängigkeit von dem Betriebszustand der Brennkraftmaschine mehrere in einer Gruppe zusammengefaßte Zündvorgänge ausgelöst werden. Im Teilbild a sind beispielsweise drei Zündimpulse 31, 31a, 31b in einer Gruppe 32 zusammengefaßt. Eine derartige Funkenbandzündung verbessert insbesondere die Kaltstarteigenschaften durch das Sicherstellen eines ordnungsgemäßen Zündvorgangs. Mit dieser Maßnahme wird im wesentlichen eine Abgas reduzierung oder das Erreichen einer bestimmten Abgaszusammensetzung möglich. Die im Teilbild a auf die Zündimpulse 31, 31a folgenden Funkenstandzeiten T_{B1}, T_{B2} sind jeweils reduziert. Lediglich die Funkenstandzeit T_{B3}, die auf den dritten Zündimpuls 31b folgt, weist eine bekannte maximal vorgebbare Funkenstandzeit T_{B3} auf. Ein neuer Zyklus beginnt mit dem ersten Zündimpuls 31 einer nachfolgenden Gruppe 33 von Zündimpulsen 31, 31a.

Das erste Eingangssignal 12 wird im Komparator 13 mit wenigstens einem vorgebbaren Schwellwert verglichen. Der Schwellwert kann beispielsweise derart festgelegt werden, daß die Zündimpulse 31, 31a, 31b zu einer Schwellenüberschreitung führen. Bei jeder Schwellenüberschreitung erzeugt die nachgeschaltete monostabile Kippstufe 14 einen Impuls mit vorgegebener Dauer. Das Ausgangssignal der monostabilen Kippstufe 14 kann beispielsweise aussehen wie das im Teilbild b von Figur 2 gezeigte impulsförmige Signal. Wesentlich bei diesem impulsförmigen Signal ist, daß jedem in der Zündanlage auftretenden Schaltvorgang ein Impuls 34, 34a, 34b zugeordnet ist. Die Impulse 34, 34a, 34b könnten beispielsweise auch jeweils zu Beginn der Schließphasen 30, 30a, 30b oder beispielsweise am Ende der Funkenstandzeiten T_{B1}, T_{B2}, T_{B3} auftreten. Im Teilbild b beginnen die Impulse 34, 34a, 34b beispielsweise gleichzeitig mit dem Auftreten der Zündimpulse 31, 31a, 31b. Die Abstände T₁, T₂ zwischen den Impulsen 34, 34a, 34b entsprechen den Abständen zwischen Zündvorgängen, die innerhalb einer Gruppe 32, 33 auftreten.

Das impulsförmige Signal gemäß Teilbild b von Figur 2 entspricht einem herkömmlichen, aus dem Stand der Technik bekannten Signal, das beispielsweise zur Auswertung einer Drehzahl verwendbar ist. Durch das Auftreten von mehreren Zündimpulsen 31, 31a, 31b innerhalb einer Impulsgruppe 32, 33 ist das impulsförmige Signal nicht ohne weiteres zur Weiterverarbeitung geeignet. Eine Auswertung beispielsweise der Drehzahl ist nicht mehr möglich, wenn die Anzahl der Zündimpulse 31, 31a, 31b innerhalb einer Impulsgruppe 32, 33 nicht konstant ist und eine entsprechende Information über die Anzahl von einem Zündungsschaltgerät nicht zur Verfügung gestellt wird.

Das erfindungsgemäße Verfahren ermöglicht die Ausblendung von Zündimpulsen 31a, 31b, die auf den ersten Impuls 31 einer Impulsgruppe 32, 33 folgen. Das impulsförmige Signal gemäß dem Teilbild b, das am Ausgang der monostabilen Kippstufe 14 auftritt, gelangt über den Umschalter 15 auf den retriggerbaren Zeitgeber 16. Der retriggerbare Zeitgeber 16 ist ein Zeitgeber, der durch das Auftreten eines Impulses 34, 34a, 34b des impulsförmigen Signals in eine aktive Phase T_{A}, T'_{A} schaltbar ist. Der Begriff retriggerbar bedeutet, daß jeder Impuls 34, 34a, 34b den Startwert für die Festlegung einer vorgegebenen Zeit T_{V}, T'_{V} des Zeitgebers 16 auf den Wert 0 zurücksetzt. Im Teilbild c von Figur 2 löst der erste Impuls 34 die aktive Phase mit der Dauer T_{A}, T'_{A} aus. Der nächste Impuls 34a sowie der darauffolgende Impuls 34b setzen jeweils den retriggerbaren Zeitgeber 16 auf den Wert 0 zurück, von dem ausgehend die vorgegebene Zeit T_{V}, T'_{V} zu laufen beginnt. Wesentlich für die ordnungsgemäße Arbeitsweise des erfindungsgemäßen Verfahrens ist, daß die vorzugebende Zeit T_{V}, T'_{V} länger ist als der maximale Abstand T₁, T₂ zwischen den Impulsen 34, 34a, 34b einer Impulsgruppe 32, 33. Die im Teilbild c eingezeichnete vorzugebende Zeit T_{V} erfüllt diese wesentliche Mindestbedingung. In einer vorteilhaften Weiterbildung kann vorgesehen sein, daß die vorzugebende Zeit T_{V}, T'_{V} länger ist als die bekannte, maximal vorgegebene Funkenstandzeit T_{B1}, T_{B2}, T_{B3}. Bei einer Funkenbandzündung ist davon auszugehen, daß die letzte Funkenstandzeit T_{B3} in einer Impulsgruppe 32, 33 die längste Dauer aufweist, auf welche die vorzugebende Zeit T_{V}, T'_{V} abzustimmen ist. Im Teilbild c ist die vorzugebende Zeit auf den Wert T'_{V} festzulegen. Mit dieser Maßnahme wird eine weitgehende Unterdrückung von Störimpulsen erreicht. Solche Störimpulse könnten beispielsweise am Ende der Funkenstandzeiten T_{B1}, T_{B2}, T_{B3} auftreten. Die aktive Phase T_{A} im Teilbild c korrespondiert mit der vorzugebenden Zeit T_{V} und die aktive Phase T'_{A} korrespondiert mit der vorzugebenden Zeit T'_{V} gemäß Weiterbildung.

Die Differenzieranordnung 20 ermittelt aus dem im Teilbild c von Figur 2 gezeigten Signal durch Auswerten der positiven Signalflanken das im Teilbild d von Figur 2 gezeigte Triggersignal 21, das der signalverarbeitenden Anordnung 22 zugeleitet ist. Anstelle der Auswertung der positiven Signalflanke kann ebensogut die negative Signalflanke des im Teilbild c gezeigten Signals ausgewertet werden. Das wesentliche Ergebnis ist der Abstand Tₙ zwischen den ersten Impulsen 31 von aufeinanderfolgenden Impulsgruppen 32, 33. Das Triggersignal 21 ist von den Impulsen 34a, 34b, die auf den ersten Impuls 34 innerhalb einer Impulsgruppe 32, 33 folgen, befreit. Der Abstand Tₙ kann deshalb unmittelbar in eine Drehzahl umgerechnet werden.

Eine Weiterbildung sieht vor, daß anstelle des Ausgangssignals der monostabilen Kippstufe 14 das Zündfunkenunterdrückungssignal 17 dem retriggerbaren Zeitgeber 16 zugeführt wird. Die Umschaltung erfolgt mit dem Umschalter 15. Die Zündfunkenunterdrückungsvorrichtung 18 ist beispielsweise ein steuerbarer Kurzschließer für die Primärwicklung einer Zündspule zum zeitgenauen Unterdrücken von Zündvorgängen. Die Unterdrückung von Zündvorgängen ist beispielsweise bei einer Laufzustandsanalyse vorgesehen, bei der die Zündfunken einzelner Zylinder unterdrückt werden. Eine andere Anwendung ist gegeben bei einer Diagnose des Anlassers. Mit dieser Ausgestaltung soll verdeutlicht werden, daß die Erzeugung eines Zündfunkens für den Ablauf des erfindungsgemäßen Verfahrens nicht zwingend erforderlich ist. Das im Teilbild b von Figur 2 gezeigte impulsförmige Signal kann daher beispielsweise auch das Zündfunkenunterdrückungssignal 17 sein. Wesentlich ist lediglich, daß das im Teilbild b von Figur 2 gezeigte impulsförmige Signal jedem Schaltvorgang in der Zündanlage einen Impuls 34, 34a, 34b zuordnet.

Gemäß Figur 1 ist das Eingangssignal des retriggerbaren Zeitgebers 16 auf den Komparator 13 zurückgeführt. Mit dieser Maßnahme ist eine Umschaltung des Schwellwerts während dem Vorliegen des Ausgangssignals der monostabilen Kippstufe 14 möglich. Diese Maßnahme kann zu einer weiteren Erhöhung der Sicherheit gegenüber Störsignalen eingesetzt werden.

Das Eingangssignal des retriggerbaren Zeitgebers 16 ist auch der signalverarbeitenden Anordnung 22 unmittelbar zugeführt. Die signalverarbeitende Anordnung 22 kann mit der Information des impulsförmigen Signals gemäß Teilbild b von Figur 2 beispielsweise feststellen, ob die Funkenbandzündung auftritt und es können beispielsweise die Impulse 34, 34a, 34b gezählt werden, die innerhalb einer Impulsgruppe 32, 33 auftreten. Mit der bekannten Information über die Drehzahl kann festgestellt werden, ob die aufgetretene Impulsanzahl mit der Sollvorgabe übereinstimmt.

Eine besonders vorteilhafte Weiterbildung sieht die Beeinflussung der vorzugebenden Zeit T_{V}, T'_{V} für den retriggerbaren Zeitgeber 16 über das Steuersignal 24 vor. In einer einfachen Ausgestaltung kann vorgesehen sein, daß der retriggerbare Zeitgeber 16 nach dem Überschreiten eines vorgegebenen Schwellwertes der Drehzahl vollständig abgeschaltet ist. In einer anderen Ausgestaltung kann vorgesehen sein, daß die vorzugebende Zeit T_{V}, T'_{V} in Abhängigkeit von der Drehzahl variiert. Mit zunehmender Drehzahl wird die vorzugebende Zeit T_{V}, T'_{V} reduziert. Diese Ausgestaltung kann mit der vollständigen Abschaltung des retriggerbaren Zeitgebers 16 nach dem Überschreiten des Drehzahlschwellwerts kombiniert werden.

In einer anderen Ausgestaltung kann die vorzugebende Zeit T_{V}, T'_{V} in Abhängigkeit von der Anzahl der aufgetretenen Impulse 34, 34a, 34b innerhalb einer Impulsgruppe 32, 33 festgelegt werden. Vorteilhafter Weise wird der retriggerbare Zeitgeber 16 abgeschaltet, wenn außer dem ersten Impuls 34 kein weiterer Impuls in der Impulsgruppe 32, 33 auftritt.

In einer weiteren Ausgestaltung kann vorgesehen sein, den retriggerbaren Zeitgeber 16 abzuschalten, wenn nach Ablauf einer vorgegebenen Zeit kein Flankenwechsel mehr auftritt. Dieser Betriebszustand tritt auf, wenn ständig neu getriggert wird und somit die aktive Phase T_{A}, T'_{A} gegen große Zeiten strebt. In weiteren Ausgestaltungen kann vorgesehen sein, daß die vorzugebende Zeit T_{V}, T'_{V} in Abhängigkeit von Werten erfolgt, die über die Eingabe 23 der signalverarbeitenden Anordnung 22 zugeleitet werden. Solche Werte sind beispielsweise Informationen über die Brennkraftmaschine, beispielsweise die Zylinderzahl. Weitere Informationen können die Zündanlage betreffen. Unterschiedliche Ausführungen der Zündanlage wurden bereits eingangs angegeben.

Eine Abschaltung des retriggerbaren Zeitgebers 16 ist in der Weise zu verstehen, daß das impulsförmige Signal gemäß Teilbild b von Figur 2, das dann lediglich noch den ersten Impuls 34 enthält, ohne Beeinflussung den retriggerbaren Zeitgeber 16 passieren kann.

Das erfindungsgemäße Verfahren kann sowohl mit schaltungstechnischen Maßnahmen als auch vorzugsweise im Rahmen eines in einem Mikroprozessorsystem enthaltenen Programmes realisiert sein. Eine digitale Signalverarbeitung ist ohne weiteres nach dem Auftreten des impulsförmigen Signals gemäß Teilbild b von Figur 2 möglich, sofern die Impulse 34, 34a, 34b entsprechende Pegel aufweisen. Eine vollständige digitale Signalverarbeitung wird möglich, wenn anstelle des beispielhaft eingesetzten Komparators 13 zur Aufbereitung des ersten Eingangssignals 12 bereits ein Analog/Digital-Wandler vorgesehen ist.

## Patentansprüche

1. Verfahren zum Prüfen einer fremdgezündeten Brennkraftmaschine, bei dem ein aus der Zündung abgeleitetes impulsförmiges Signal bereitgestellt wird, das jedem bei der Zündung auftretenden Schaltvorgang einen Impuls (34, 34a, 34b) zuordnet, bei dem eine Impulsverarbeitung mit einem retriggerbaren Zeitgeber (16) erfolgt, dem die Impulse (34, 34a, 34b) zugeführt werden und der ein Triggersignal (21) abgibt, aus dem zumindest die Drehzahl der Brennkraftmaschine ermittelbar ist und
- bei dem eine monostabile Kippstufe (14) vorgesehen ist, der das aus der Zündung abgeleitete Signal zugeleitet wird und welche die Impulse (34, 34a, 34b) mit einer vorgegebenen Dauer bereitstellt,
- bei die dem Impulse (34, 34a, 34b) aus einer Zündanlage gewonnen werden, die, zumindest bei niedrigen Drehzahlen der Brennkraftmaschine, zum Auslösen eines Zünävorgangs mehrere, zu einer Gruppe (32, 33) zusammengefaßte Zündimpulse (31, 31a, 31b) erzeugt,
- bei dem die für den retriggerbaren Zeitgeber (14) vorzugebende Zeit (T_{V}, T'_{V}) länger ist als der maximale Abstand (T1, T2) zwischen den Impulsen (34, 34a, 34b) einer Impulsgruppe (32, 33), derart, daß während der aktiven Phase (T_{A}, T'_{A}) des retriggerbaren Zeitgebers (16) die dem ersten Impuls (34) folgenden Impulse (34a, 34b) der Impulsgruppe (32, 33) unterdrückt werden, und
- bei dem eine signalverarbeitende Anordnung (22) vorhanden ist, die aus dem Triggersignal (21) die Drehzahl der Brennkraftmaschine ermittelt, mit einem vorgegebenen Schwellenwert vergleicht und bei einer Schwellenüberschreitung ein Steuersignal abgibt, das den retriggerbaren Zeitgeber (16) abschaltet, so daß die von der monostabilen Kippstufe (14) bereitgestellten Impulse (34) mit vorgegebener Dauer unmittelbar als Triggersignal (21) weitergeleitet werden.

2. Verfahren nach Anspruch 1, dadurch gekennzeichnet, daß die für den retriggerbaren Zeitgeber (16) vorzugebende Zeit (T_{V'}, T'_{V}) in Abhängigkeit von der Drehzahl der Brennkraftmaschine festgelegt wird.

3. Verfahren nach Anspruch 1, dadurch gekennzeichnet, daß die für den retriggerbaren Zeitgeber (16) vorzugebende Zeit (T_{V'}, T'_{V}) in Abhängigkeit von der Anzahl der zu unterdrückenden Impulse (34a, 34b) festgelegt wird.

4. Verfahren nach Anspruch 1, dadurch gekennzeichnet, daß die für den retriggerbaren Zeitgeber (16) vorzugebende Zeit (T_{V'}, T'_{V}) in Abhängigkeit von der Anzahl der Zylinder der Brennkraftmaschine festgelegt wird.

5. Verfahren nach Anspruch 1, dadurch gekennzeichnet, daß die für den retriggerbaren Zeitgeber (16) vorzugebende Zeit (T_{V}, T'_{V}) in Abhängigkeit von der Ausgestaltung der Zündanlage festgelegt wird.

6. Verfahren nach Anspruch 1, dadurch gekennzeichnet, daß der retriggerbare Zeitgeber (16) abgeschaltet wird, wenn die aktive Phase (T_{A}, T'_{A}) einen vorgegebenen zeitlichen Schwellenwert übersteigt.

## Claims

1. Process for testing a spark-ignition internal combustion engine, in which process a pulse-shaped signal derived from the ignition is made available and assigns a pulse (34, 34a, 34b) to each switching process occurring during the ignition, in which process pulse processing with a retriggerable timer (16) takes place, to which timer (16) the pulses (34, 34a, 34b) are fed and which emits a trigger signal (21) from which at least the rotational speed of the internal combustion engine can be determined and
- in which process a monostable flip-flop (14) is provided to which the signal derived from the ignition is fed and which makes the pulses (34, 34a, 34b) available with a prescribed duration,
- in which process the pulses (34, 34a, 34b) are acquired from an ignition system which, at least at low rotational speeds of the internal combustion engine, generates a plurality of ignition pulses (31, 31a, 31b), combined to form a group (32, 33), in order to trigger an ignition process,
- in which process the time (Tᵥ, T'_{V}) which is to be prescribed for the retriggerable timer (14) is longer than the maximum interval (T1, T2) between the pulses (34, 34a, 34b) of a pulse group (32, 33) such that during the active phase (T_{A}, T'_{A}) of the retriggerable timer (16) the pulses (34a, 34b) of the pulse group (32, 33) which follow the first pulse (34) are suppressed, and
- in which process a signal-processing arrangement (22) is present which determines the rotational speed of the internal combustion engine from the trigger signal (21), compares it with a prescribed threshold value and, when the threshold is exceeded, emits a control signal which switches off the retriggerable timer (16) so that the pulses (34) which are made available by the monostable flip-flop (14) are directly passed on with a prescribed duration as trigger signal (21).

2. Process according to Claim 1, characterized in that the time (T_{V}, T'_{V}) which is to be prescribed for the retriggerable timer (16) is specified as a function of the rotational speed of the internal combustion engine.

3. Process according to Claim 1, characterized in that the time (T_{V}, T'_{V}) which is to be prescribed for the retriggerable timer (16) is specified as a function of the number of pulses (34a, 34b) to be suppressed.

4. Process according to Claim 1, characterized in that the time (T_{V}, T'_{V}) which is to be prescribed for the retriggerable timer (16) is specified as a function of the number of cylinders of the internal combustion engine.

5. Process according to Claim 1, characterized in that the time (T_{V}, T'_{V}) which is to be prescribed for the retriggerable timer (16) is specified as a function of the configuration of the ignition system.

6. Process according to Claim 1, characterized in that the retriggerable timer (16) is switched off if the active phase (T_{A}, T'_{A}) exceeds a prescribed time threshold value.

## Revendications

1. Procédé de contrôle d'un moteur à combustion interne à allumage commandé selon lequel
- on fournit un signal impulsionnel déduit de l'allumage, qui associe une impulsion (34, 34a, 34b) à chaque commutation se produisant à l'allumage,
- on traite l'impulsion avec une horloge redéclenchable (16) recevant les impulsions (34, 34a, 34b) et fournissant un signal de déclenchement (21) à partir duquel on peut déterminer au moins la vitesse de rotation du moteur à combustion interne et,
- une bascule monostable (14) reçoit le signal déduit de l'allumage et fournit des impulsions (34, 34a, 34b) de durée prédéterminée,
- les impulsions (34, 34a, 34b) sont obtenues à partir d'une installation d'allumage qui génère au moins aux vitesses de rotation faibles du moteur à combustion interne, pour le déclenchement d'une opération d'allumage, plusieurs impulsions d'allumage (31, 31a, 31b) réunies en un groupe (32, 33),
- selon lequel la durée prédéterminée (T_{V}, T'_{V}) pour l'horloge redéclenchable (16) est plus longue que l'intervalle maximum (T₁, T₂) entre les impulsions (34, 34a, 34b) d'un groupe d'impulsions (32, 33) de façon que pendant la phase active (T_{A}, T'_{A}) de l'horloge redéclenchable (16), les impulsions (34a, 34b) du groupe d'impulsions (32, 33) qui suivent la première impulsion (34) soient supprimées et,
- un dispositif de traitement de signal (22), qui à partir du signal de déclenchement (21), détermine la vitesse de rotation du moteur à combustion interne, la compare à un seuil prédéterminé et en cas de dépassement du seuil fournit un signal de commande qui coupe l'horloge redéclenchable (16) pour que les impulsions (34) fournies par la bascule monostable (14) avec une durée prédéterminée, soient transmises directement comme signal de déclenchement (21).

2. Procédé selon la revendication 1,
caractérisé en ce que
la durée (T_{V}, T'_{V}) prévue pour l'horloge redéclenchable (16) est fixée en fonction de la vitesse de rotation du moteur à combustion interne.

3. Procédé selon la revendication 1,
caractérisé en ce que
la durée prédéterminée (T_{V}, T'_{V}) prévue pour l'horloge redéclenchable (16) est fixée en fonction du nombre d'impulsions à supprimer (34a, 34b).

4. Procédé selon la revendication 1,
caractérisé en ce que
la durée (T_{V}, T'_{V}) prédéterminée pour l'horloge redéclenchable (16) est fixée en fonction du nombre de cylindres du moteur à combustion interne.

5. Procédé selon la revendication 1,
caractérisé en ce que
la durée (T_{V}, T'_{V}) prédéterminée pour l'horloge redéclenchable (16) est fixée en fonction de la réalisation de l'installation d'allumage.

6. Procédé selon la revendication 1,
caractérisé en ce que
l'horloge redéclenchable (16) est coupée lorsque la phase active (T_{A}, T'_{A}) dépasse un seuil de temps prédéterminé.
